# FASCICULE DE BREVET EUROPEEN

(11) **EP 0 635 995 B1**
(45) Date de publication et mention de la délivrance du brevet: **29.12.1997**
(21) Numéro de dépôt: 94401675.7
(22) Date de dépôt: 21.07.1994
(51) Int. Cl.: H05K 1/00

(54) **Circuit flexible de raccordement d'un circuit imprimé**
Flexible Schaltung zur Verbindung von Leiterplatten
Flexible circuit for connecting printed circuit boards

(30) Priorité: 22.07.1993 FR 9309012
(43) Date de publication de la demande: 25.01.1995
(73) Titulaire: SOCIETE D'APPLICATIONS GENERALES D'ELECTRICITE ET DE MECANIQUE SAGEM, F-75783 Paris Cédex 16 (FR)
(72) Inventeur: Ricouard, Jean-Pierre, F-95610 Eragny sur Oise (FR)
(74) Mandataire: Bloch, Gérard

(56) Documents cités:
- FR-A- 2 673 772
- ASSEMBLY ENGINEERING, vol.31, no.5, Mai 1988, WHEATON IL US pages 32 - 36 C.D. KEIRSTEAD 'Flexible printed circuits: a design primer'
- ELECTRONIC PACKAGING AND PRODUCTION, vol.28, no.8, Août 1988, MASSACHUSETTS US pages 32 - 34, XP432 J.C. FJELSTAD 'Design guidelines for flexible circuits'

## Description

Un circuit flexible de raccordement d'un circuit imprimé sert à raccorder une carte de circuit imprimé à d'autres cartes ou composants électriques. Il peut s'agir d'une nappe de conducteurs, déposés sur un support flexible et solidaires de broches d'un connecteur d'un boîtier récepteur. Il en est ainsi, par exemple, des cartes de circuit imprimé à bord des véhicules automobiles. Les broches évitent l'emploi de contacts mobiles, sensibles aux pollutions et, du fait de la flexibilité du support, au-delà de ces broches, on peut inspecter la carte en la faisant pivoter hors de son boîtier tout en la conservant en fonctionnement.

Pour son raccordement à la carte, à son autre extrémité, le circuit flexible peut être rapporté en bout de carte ou constituer un prolongement d'une carte souple.

Or, les contraintes de contraction / dilatation apparaissant lors des pivotements du support ne sont pas réparties également tout au long du circuit flexible, car les broches,et par exemple les gouttes de soudure qui les fixent, présentent une inertie mécanique à la flexion bien supérieure à celle du circuit flexible. Il peut se produire des contraintes localisées génératrices, à terme, de fissures coupant les conducteurs ou créant, au ras des broches, des faux contacts.

Un connecteur électrique pour le raccordement d'un circuit souple est connu de FR-A-2 673 772.

Le document ASSEMBLY ENGINEERING, vol. 31, No 5, mai 1988, enseigne bien de coller au circuit flexible une plaque raidisseur dans la zone des trous de raccordement électrique de broches, mais cette solution est coûteuse en matériel et en temps de montage et est encombrante.

La présente invention vise à pallier ces inconvénients.

A cet effet, elle concerne un circuit flexible de raccordement d'un circuit imprimé, comportant un support flexible avec au moins un conducteur de raccordement pourvu d'une plage conductrice terminale de raccordement à une broche de raccordement, des moyens de réception de moyens de rigidification d'une portion du support flexible, la portion de conducteur adjacente à la plage terminale s'étendant sur ladite portion du support flexible, caractérisé par le fait que les moyens de réception sont agencés pour recevoir une broche de rigidification.

Ainsi, la rigidification de la portion de support flexible peut s'effectuer très simplement, par exemple par enfichage de la broche de rigidification dans un trou du support flexible et soudage à la vague.

Dans une première forme de réalisation, la broche de raccordement étant une broche de rigidification de ladite portion du support flexible, le conducteur s'étend jusqu'à la plage de raccordement et de réception de la broche par au moins une portion de conducteur coudée.

Dans une deuxième forme de réalisation, il est prévu une broche de rigidification reçue sur une plage isolée, la portion du conducteur adjacente à la plage de raccordement pouvant être rectiligne.

L'invention sera mieux comprise à l'aide de la description suivante de la forme de réalisation de deux variantes préférées du circuit flexible de l'invention, en référence au dessin annexé, sur lequel:
- la figure 1 est une vue en perspective de la première variante et
- la figure 2 est une vue de dessus de la deuxième variante.

Le circuit flexible de raccordement électrique est, dans cet exemple, une carte électronique logée à bord d'une voiture. La carte 1 de la première variante comporte des composants, non représentés, refroidis par un radiateur 2 fixé sur la face de la carte 1 opposée à ceux-ci et qui, de ce fait, rigidifie la partie correspondante 1A de la carte 1. Une autre partie 3 de la carte 1, comportant une couche isolante, déborde du radiateur 2 et porte en surface des pistes de cuivre 4 reliant les composants ci-dessus aux broches 5, ici alignées, d'un connecteur 6 solidaire d'un boîtier 7, représenté schématiquement, contenant la carte 1. Les broches 5 traversent des trous au centre de plages de soudage 8 situées en surface de la partie flexible 3 et sont soudées à ces plages 8, elles-mêmes reliées aux pistes 4 par des zones de jonction 9.

Dans cet exemple où les broches 5 sont alignées, la partie flexible 3 peut pivoter autour d'un axe 10 tangent aux bords des plages 8 tournés vers la partie rigide 1A de la carte 1. Une flexion ou un vrillage de la partie flexible 3 peuvent aussi avoir lieu selon d'autres axes éventuellement parallèles à l'axe 10, ou bien selon des axes non parallèles à l'axe 10, comme les axes 11, 12, tangents au plan de la partie flexible 3 au niveau de l'une ou l'autre des deux plages 8 en extrémité de la rangée de broches 5.

La partie flexible 3 comporte, à son extrémité opposée à la partie rigide 1A de la carte 1, un secteur 13, sensiblement limité par la rangée de plages 8 et les axes 11, 12, non susceptible de subir des contraintes provenant de la partie rigidifiée de la carte 1, puisque les broches 5, soudées aux plages 8, présentent une inertie mécanique empêchant toute déformation à leur niveau et du côté opposé à celui d'où proviennent les contraintes dues au mouvement de la partie rigide 1A.

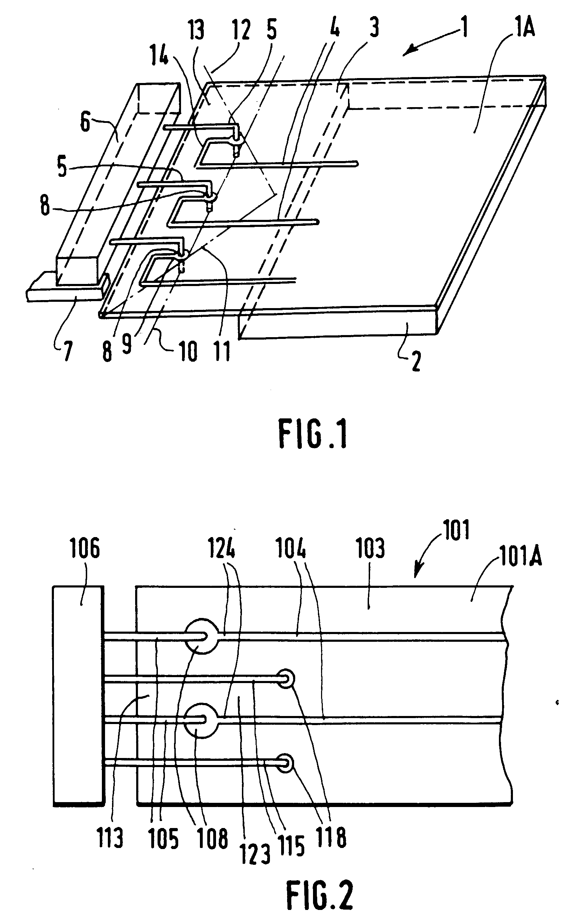

Comme le montre la figure 1, les pistes 4 se raccordent aux plages 8 dans le secteur 13, par des parties coudées 14 et repliées sur elles-mêmes dans cet exemple, si bien que la discontinuité d'inertie mécanique à la flexion, entre les plages 8, avec les broches 5, et les zones de jonction 9, n'a pas d'effet destructeur, faute de flexion à cet endroit.

La deuxième variante de réalisation, représentée sur la figure 2, diffère de la première variante par le fait que le connecteur comporte deux rangées parallèles de broches, ici en quinconce, 105 et 115. Les éléments correspondant à ceux de la figure 1 portent les mêmes références que ceux-ci, précédées de la centaine 1.

Les broches 115 sont les plus proches de la partie rigide 101A de la carte 101, tandis que les broches 105, plus proches du connecteur 106, sont reliées, par des plages 108, à des portions rectilignes 124 de pistes 104 passant entre les broches 115. Les broches 115 sont soudées dans des trous métallisés 118 de la partie flexible 103 isolés du reste de la carte 101 et elles empêchent la propagation vers le connecteur 106, dans la portion flexible 103, de déformations provenant de la partie rigide 101A de la carte 101. En particulier, les broches 105, 115 entourent une portion réduite 123 de la carte 101 non susceptible de subir des contraintes, de quelque direction qu'elles proviennent, et la rigidifient efficacement.

Pour ce qui est de la résistance mécanique à la flexion, au niveau des soudures, la double rangée de broches 105, 115 offre un couple résistant à la flexion qui est accru par augmentation du bras de levier, c'est-à-dire de la distance les séparant, alors qu'il était limité au diamètre des plages 8 dans la première variante.

On comprendra que les broches 115 pourraient aussi, comme les broches 5, être raccordées à des pistes 104. De même, des connexions mécaniques et électriques autres que des soudures pourraient être utilisées pour relier les pistes 4, 104 aux broches 5, 105.

## Revendications

1. Circuit flexible de raccordement d'un circuit imprimé, comportant un support flexible (3; 103) avec au moins un conducteur de raccordement (4; 104) pourvu d'une plage conductrice terminale (8; 108) de raccordement à une broche de raccordement (5; 105), des moyens de réception (8; 108; 118) de moyens de rigidification (5; 105; 115) d'une portion (13; 113) du support flexible (3; 103), la portion (9) de conducteur adjacente à la plage terminale (8; 108) s'étendant sur ladite portion (13; 113) du support flexible (3; 103), caractérisé par le fait que les moyens de réception (8; 108; 118) sont agencés pour recevoir une broche de rigidification (5; 105; 115).

2. Circuit selon la revendication 1, dans lequel, la broche de raccordement (5) étant une broche de rigidification de ladite portion (13) du support flexible (3), le conducteur (4) s'étend jusqu'à la plage de raccordement et de réception (8) de la broche (5) par au moins une portion de conducteur coudée (14).

3. Circuit selon l'une des revendications 1 et 2, dans lequel la portion (14) du conducteur (4) adjacente à la plage de raccordement (8) est repliée sur elle-même.

4. Circuit selon la revendication 1, dans lequel il est prévu une broche de rigidification (115) reçue sur une plage isolée (118).

5. Circuit selon l'une des revendications 1 et 4, dans lequel la portion (124) du conducteur (104) adjacente à la plage de raccordement (108) est rectiligne.

## Patentansprüche

1. Flexible Schaltung zum Anschließen einer gedruckten Schaltung, die folgendes aufweist: einen flexiblen Träger (3; 103) mit mindestens einem Verbindungsleiter (4; 104), der mit einem leitenden Endbereich (8; 108) zur Verbindung mit einem Verbindungsstift (5; 105) versehen ist, und Aufnahmeeinrichtungen (8; 108; 118) für Versteifungseinrichtungen (5; 105; 115) eines Bereiches (13; 113) des flexiblen Trägers (3; 103), wobei der an den Endbereich (8; 108) angrenzende Leiterbereich (9) sich auf diesem Bereich (13; 113) des flexiblen Trägers (3; 103) erstreckt,
dadurch gekennzeichnet,
daß die Aufnahmeeinrichtungen (8; 108; 118) dafür ausgelegt sind, einen Versteifungsstift (5; 105; 115) aufzunehmen.

2. Schaltung nach Anspruch 1,
bei der dann, wenn der Verbindungsstift (5) ein Stift zur Versteifung dieses Bereiches (13) des flexiblen Trägers (3) ist, der Leiter (4) sich über mindestens einen gebogenen Leiterabschnitt (14) bis zu dem Bereich (8) zur Verbindung und zur Aufnahme des Stifts (5) erstreckt.

3. Schaltung nach einem der Ansprüche 1 und 2,
bei der der an den Verbindungsbereich (8) angrenzende Bereich (14) des Leiters (4) auf sich selbst umgebogen ist.

4. Schaltung nach Anspruch 1,
bei der ein Versteifungsstift (115) vorgesehen ist, der von einem isolierten Bereich (118) aufgenommen ist.

5. Schaltung nach einem der Ansprüche 1 und 4,
bei der der an den Verbindungsbereich (108) angrenzende Bereich (124) des Leiters (104) geradlinig ist.

## Claims

1. Flexible circuit for the connection of a printed circuit, comprising a flexible support (3; 103) with at least one connecting conductor (4; 104) provided with an end conducting area (8; 108) for connection to a connecting pin (5; 105), means (8 ; 108 ; 118) for receiving Leans (5;105;115) for making a portion (13; 113) of the flexible support (3; 103) rigid, the portion (9) of the conductor adjacent to the end area (8; 108) extending over said portion (13; 113) of the flexible support (3; 103), characterised by the fact that the receiving means (8; 108; 118) are arranged to receive a rigidification pin (5; 105; 115).

2. Circuit according to Claim 1, in which, the connecting pin (5) being a pin for making said portion (13) of the flexible support (3) rigid, the conductor (4) extends as far as the area (8) for the connection and reception of the pin (5) by at least one bent portion of conductor (14).

3. Circuit according to one of Claims 1 and 2, in which the portion (14) of the conductor (4) adjacent to the connecting area (8) is bent back on itself.

4. Circuit according to Claim 1, in which a rigidification pin (115) received in an isolated area (118) is provided.

5. Circuit according to one of Claims 1 and 4, in which the portion (124) of the conductor (104) adjacent to the connecting area (108) is rectilinear.
